# EUROPEAN PATENT APPLICATION

(11) **EP 2 782 234 A1**
(43) Date of publication of application: **24.09.2014**
(21) Application number: 14158584.4
(22) Date of filing: 10.03.2014
(51) Int. Cl.: H02M 1/088, H03K 17/12, H03K 17/74, H03K 17/0814

(54) **Rectifier and method for controlling the same**

(30) Priority: 22.03.2013 JP 2013061140
(71) Applicant: Kabushiki Kaisha Toshiba, Tokyo (JP)
(72) Inventor: Takao, Kazuto, Tokyo (JP); Ota, Chiharu, Tokyo (JP); Nishio, Johji, Tokyo (JP); Shinohe, Takashi, Tokyo (JP)
(74) Representative: Granleese, Rhian Jane

(57) **Abstract**

According to one embodiment, a rectifier (110) includes a rectifying device (10), a control element (20) and a controller (30). The control element (20) is serially connected to the rectifying device (10). The control element (20) has a resistance value that changes according to a control signal (CS). The controller (30) generates the control signal (CS) according to a change in a current (i₁₀) flowing in the rectifying device (10).

## Description

### FIELD

Embodiments described herein relate generally to a rectifier and a method for controlling the same.

### BACKGROUND

Forward voltage (Vf) of a rectifying device has temperature dependence. In the temperature dependence, a negative temperature characteristic is a characteristic where forward voltage drops due to a rise in temperature, and a positive temperature characteristic is a characteristic where forward voltage rises due to a rise in temperature. For example, a PiN diode made of silicon carbide (SiC) generally has a negative temperature characteristic. Balancing current between devices is critical when connecting a plurality of rectifying devices in parallel. In other words, if more current is flowing in a specific rectifying device of a plurality of rectifying devices connected in parallel, there will be a greater burden on that rectifying device. Stable operation of rectifying devices is desired in a rectifier.

### BRIEF DESCRIPTION OF THE DRAWINGS

FIG. 1 is a drawing illustrating a rectifier according to the first embodiment;
FIG. 2 is a flowchart illustrating a method for controlling the rectifier according to the second embodiment;
FIG. 3 is a flowchart illustrating a method for controlling the rectifier according to the third embodiment;
FIG. 4A and FIG. 4B are drawings showing reverse recovery characteristics of the rectifying device and changes in resistance value;
FIG. 5 is a drawing illustrating a rectifier according to the fourth embodiment;
FIG. 6 is a chart showing a relationship between current and on-state voltage of the rectifying device;
FIG. 7 is a drawing illustrating a rectifier according to the Reference Example;
FIG. 8 is a flowchart illustrating a method for controlling the rectifier according to the fifth embodiment;
FIG. 9A and FIG. 9B are drawings illustrating a semiconductor module according to the sixth embodiment; and
FIG. 10A and FIG. 10B are drawings illustrating a semiconductor module according to the seventh embodiment.

### DETAILED DESCRIPTION

In general, according to one embodiment, a rectifier includes a rectifying device, a control element and a controller. The control element is serially connected to the rectifying device. The control element has a resistance value that changes according to a control signal. The controller generates the control signal according to a change in a current flowing in the rectifying device.

Various embodiments will be described hereinafter with reference to the accompanying drawings. In the following description, the same reference numeral is applied to the same member, and for members that have been described once, the description is omitted as appropriate.

### (First Embodiment)

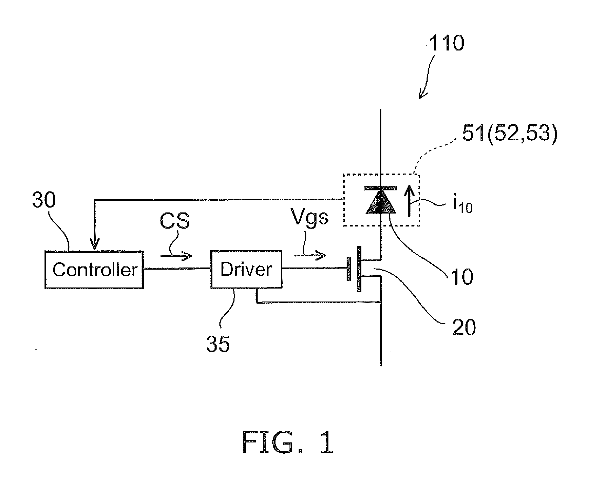

FIG. 1 is a drawing illustrating a rectifier according to the first embodiment.

As illustrated in FIG. 1, a rectifier 110 is provided with a rectifying device 10, a control element 20, and a controller 30.

The rectifying device 10 is, for example, a diode. The rectifying device 10 may also be a transistor other than a diode. In this embodiment, a PiN diode made of SiC is used as the rectifying device 10.

The control element 20 is serially connected to the rectifying device 10. The control element 20 and the rectifying device 10 may also be directly connected or may be connected with some type of device or the like therebetween. The control element 20 is connected to an anode of the diode that is the rectifying device 10. The control element 20 has a predetermined resistance value. The resistance value is, for example, a value of the on-resistance of the control element 20. The resistance value of the control element 20 changes according to a control signal CS.

The control element 20 is, for example, a metal oxide semiconductor field effect transistor (MOSFET). In addition to a MOSFET, a junction FET (JFET), high electron mobility transistor (HEMT), or the like can also be used as the control element 20. In this embodiment, a MOSFET made of silicon (Si) is used as the control element 20. The resistance value of the control element 20 changes according to a gate voltage V_{gs} applied based on the control signal CS.

The controller 30 generates the control signal CS according to a change in the current i₁₀ flowing in the rectifying device 10. The control signal CS is a signal for changing the resistance value of the control element 20 according to a change in the current i₁₀ flowing in the rectifying device 10.

In this embodiment, a driver 35 is provided between the controller 30 and the control element 20. The driver 35 generates a gate voltage V_{gs} according to the control signal CS. The gate voltage V_{gs} is applied to a MOSFET gate electrode that is the control element 20. The controller 30 may also include the driver 35. In this case, the controller 30 generates the gate voltage V_{gs} as the control signal CS.

In such a rectifier 110, the control signal CS changes according to a change in the current i₁₀ that flows in the rectifying device 10. When the gate voltage V_{gs} applied to the control element 20 changes according to the control signal CS, the resistance value of the control element 20 changes. Changing the resistance value of the control element 20 serially connected to the rectifying device 10, changes the current i₁₀ that flows in the rectifying device 10. In other words, the current i₁₀ that flows in the rectifying device 10 can be set to a desired value according to control by the controller 30.

For example, if the current i₁₀ changes according to the temperature of the rectifying device 10, then the controller 30 generates a control signal CS to change the resistance value of the control element 20 according to the change in the current i₁₀. The driver 35 generates the gate voltage Vgs according to the control signal CS. The resistance value (for example, the on-resistance value) of the control element 20 changes according to the gate voltage Vgs sent from the driver 35. By this, the current i₁₀ is controlled so as to be a constant value.

In the rectifier 110, the on-resistance value R_{on 20} of the control element 20 is less than the on-resistance value R_{on 10} of the rectifying device 10. For example, it is desired that R_{on 20} is approximately 1/10 the size compared to R_{on 10}. Selecting the control element 20 having such an on-resistance value R_{on 20} will not have significant effect on the on-resistance of the rectifying device 10 even when serially connecting the control element 20 to the rectifying device 10.

Further, in the rectifier 110, a breakdown voltage of the rectifying device 10 is greater than a breakdown voltage of the control element 20. In other words, when the rectifying device 10 is in an off-state, the breakdown voltage of the rectifying device 10 and the breakdown voltage of the control element 20 are selected so that nearly all of the voltage is applied to the rectifying device 10. For example, the breakdown voltage of the rectifying device 10 is desired to be approximately 2 digits greater than the breakdown voltage of the control element 20. Using a control element that has a low breakdown voltage as the control element 20 reduces the cost of the rectifier 110.

When using a diode made of SiC as the rectifying device 10, a MOSFET made of Si may be used as the control element 20. Because an Si MOSFET can operate at approximately 200°C, high temperature operating characteristics (for example, operating characteristics at approximately 200°C) for the SiC diode will not be sacrificed.

Further, it is desired that a normally-on type transistor is used as the control element 20. Generally, a normally-on type transistor has a lower on-resistance than a normally-off type transistor. Using a normally-on type transistor as the control element 20 allows a reduction in size of the rectifier 110 to be achieved.

Further, in the rectifier 110, use of an SiC PiN diode having a negative temperature characteristic as the rectifying device 10 also allows for stable operation. The SiC PiN diode having a negative temperature characteristic has a lower on-state voltage than an SiC PiN diode having a positive temperature characteristic, and manufacturing is easier. Using the SiC PiN diode having a negative temperature characteristic as the rectifying device 10 decreases an on-state voltage of the rectifier 110, and reduces a conduction loss.

### (Second Embodiment)

Next a second embodiment will be described.

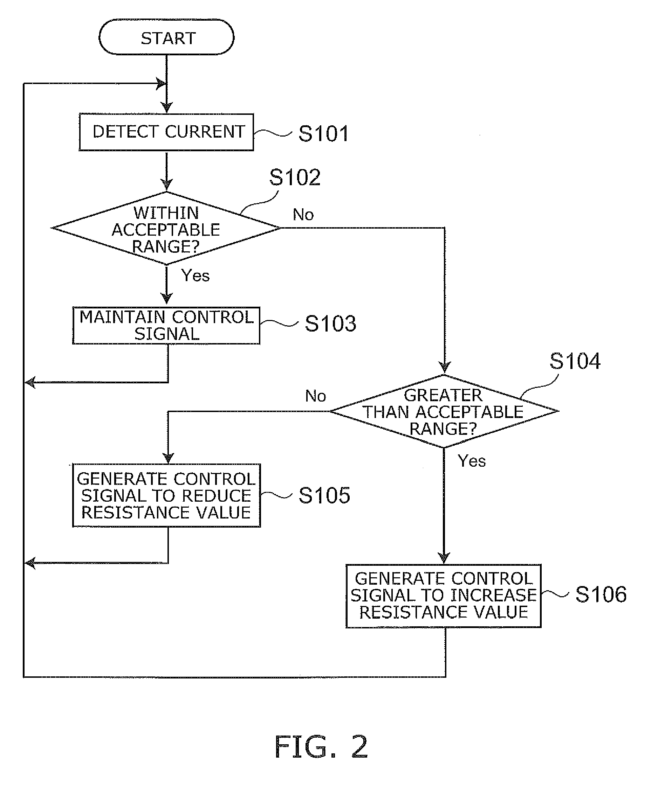

FIG. 2 is a flowchart illustrating a method for controlling the rectifier according to the second embodiment.

The flowchart illustrated in FIG. 2 is an example of a method for controlling the rectifier 110 depicted in FIG. 1. The control method illustrated in the flowchart is executed while the power is supplied to the rectifier 110.

First, as shown in step S101, the current i₁₀ that flows in the rectifying device 10 is detected. The current i₁₀ is detected by, for example, a current detector 51 provided in a circuit connected to the rectifying device 10. The current i₁₀ may be determined from the voltage detected by a voltage detector 52 provided in the circuit. Further, the current i₁₀ may be determined from the temperature detected by a temperature detector 53 provided near the rectifying device 10. The detected current i₁₀ value is sent to the controller 30.

Next, as shown in step S102, a determination is made whether or not the detected current i₁₀ value is within a predetermined acceptable range. This determination is made by the controller 30. If the detected current i₁₀ value is within the acceptable range, the process proceeds to step S103. If the detected current i₁₀ value is out of the acceptable range, the process proceeds to step S104.

In step S103, a process for maintaining the control signal CS is performed. In other words, the controller 30 maintains the generated control signal CS without changing.

In step S104, a determination is made whether or not the detected current i₁₀ value is greater than the acceptable range. This determination is made by the controller 30. If the detected current i₁₀ value is not greater than the acceptable range, the process proceeds to step S105. If the detected current i₁₀ value is greater than the acceptable range, the process proceeds to step S106.

In step S105, the control signal CS is generated by the controller 30 to reduce the resistance value of the control element 20. As the resistance value of the control element 20 is reduced according to the control signal CS, the current i ₁₀ increases. In other words, when the current i₁₀ is not more than the acceptable range, the control signal CS to reduce the resistance value of the control element 20 is generated, and by this, the current i₁₀ increases.

In step S106, a control signal CS to increase the resistance value of the control element 20 is generated by the controller 30. As the resistance value of the control element 20 is increased according to the control signal CS, the current i₁₀ decreases. In other words, when the current i₁₀ exceeds the acceptable range, the control signal CS to increase the resistance value of the control element 20 is generated, and by this, the current i₁₀ decreases.

By repeating such a process, the current i₁₀ of the rectifying device 10 is maintained within the acceptable range.

### (Third Embodiment)

Next, a third embodiment will be described.

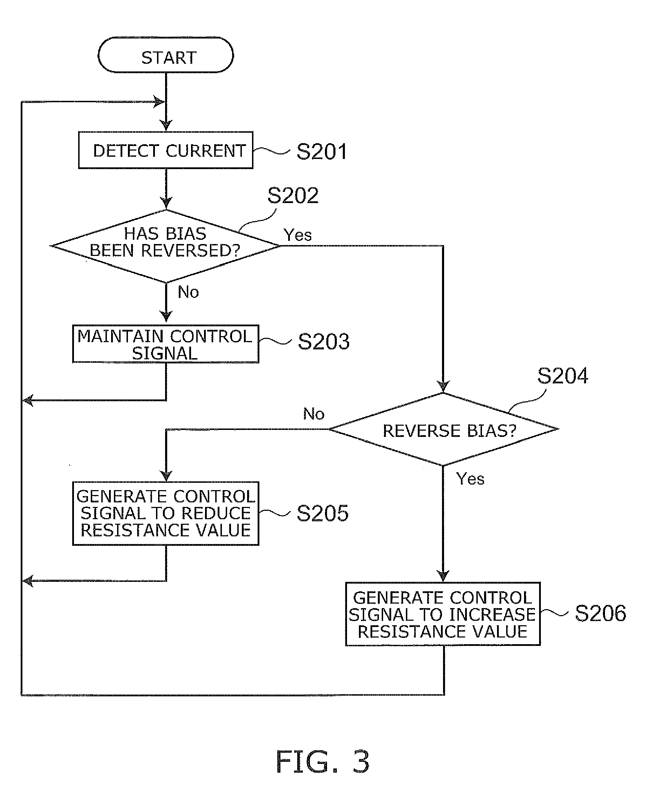

FIG. 3 is a flowchart illustrating a method for controlling the rectifier according to the third embodiment.

The flowchart illustrated in FIG. 3 is another example of a method for controlling the rectifier 110 depicted in FIG. 1. The control method illustrated in the flowchart is executed while the power is supplied to the rectifier 110.

First, as shown in step S201, the current i₁₀ that flows in the rectifying device 10 is detected. Similar to the second embodiment, the current i₁₀ can be determined from a value detected by any of the current detector 51, the voltage detector 52, or the temperature detector 53. The detected current i₁₀ value is sent to the controller 30.

Next, as shown in step S202, a determination is made whether or not a bias applied to the rectifying device 10 has been reversed. This determination is made by the controller 30. The controller 30 determines that the bias has been reversed when, for example, the bias applied to the rectifying device 10 has changed from a forward bias to a reverse bias, or when it has changed from a reverse bias to a forward bias, based on the current i₁₀ that flows in the rectifying device 10. Note that the controller 30 may determine whether or not the bias applied to the rectifying device 10 has been reversed by an external signal.

If it is determined by the controller 30 that the bias is not reversed, the process proceeds to step S203. If it is determined by the controller 30 that the bias is reversed, the process proceeds to step S204.

In step S203, a process for maintaining the control signal CS is performed. In other words, the controller 30 maintains the generated control signal CS without changing.

In step S204, a determination is made whether or not the bias applied to the rectifying device 10 has changed to the reverse bias. This determination is made by the controller 30. If it is not a reverse bias, then the process proceeds to step S205. If it is a reverse bias, then the process proceeds to step S206.

In step S205, a control signal CS to reduce the resistance value of the control element 20 is generated by the controller 30. By this, the resistance value of the control element 20 decreases while the current i₁₀ increases upon a forward bias being applied to the rectifying device 10.

In step S206, a control signal CS to increase the resistance value of the control element 20 is generated by the controller 30. The resistance value of the control element 20 is increased according to the control signal CS. When the resistance value of the control element 20 increases, fluctuation in the current and excess voltage upon reverse recovery of the rectifying device 10 are suppressed. In other words, increasing the resistance value of the control element 20 serially connected to the rectifying device 10 suppresses ringing of the current i₁₀.

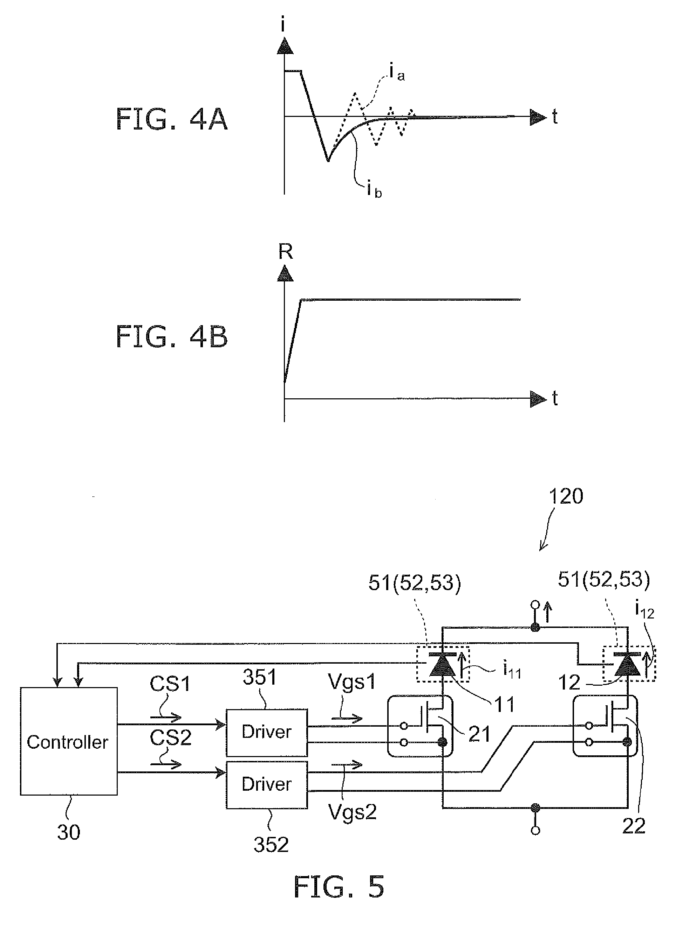

FIGS. 4A and 4B are drawings showing reverse recovery characteristics of the rectifying device and changes in resistance value.

FIG. 4A shows reverse recovery characteristics of the rectifying device, and FIG. 4B shows change in resistance value of the control element. The horizontal axis in FIGS. 4A and 4B represents time t, respectively. The vertical axis in FIG. 4A represents current i, and the vertical axis in FIG. 4B represents resistance value R of the control element. In FIG. 4A, the waveform iₐ expresses a current change when the resistance value R of the control element 20 is fixed, and the waveform i_{b} expresses the current change when the resistance value R of the control element 20 has been increased. Both waveforms express characteristics for when the rectifying device 10 is in reverse bias.

When the resistance value R of the control element 20 is fixed, a fluctuation is generated in the current such as that expressed by the waveform iₐ. Meanwhile, as shown in FIG. 4B, when the resistance value R of the control element 20 is increased when the rectifying device 10 is in reverse bias, fluctuation in the current is suppressed as expressed by the waveform i_{b}. The extent of fluctuation suppression is determined according to the size of the resistance value R of the control element 20. The controller 30 generates the control signal CS to increase the resistance value R of the control element 20.

Note that, in step S206, the controller 30 may generate a control signal CS to increase the resistance value R of the control element 20 for only a fixed period of time. The fixed period of time may be a time until the current value converges on a fixed value in the reverse recovery characteristics.

By repeating such a process, fluctuation in the current i₁₀ can be suppressed when the rectifying device 10 is in reverse bias.

Because the controller 30 can control the reverse recovery waveform of the rectifying device 10 to be active, oscillation in the current that is problematic at the time of high-speed operation of the rectifying device 10 can, as result, be suppressed.

Note that the method for controlling the rectifier 110 according to the third embodiment may be implemented in combination with the method for controlling the rectifier 110 according to the second embodiment described above. In other words, when a forward bias is applied to the rectifying device 10, the control method according to the second embodiment may be implemented, and when it makes a transition from a forward bias to a reverse bias, the control method according to the third embodiment may be implemented.

### (Fourth Embodiment)

Next, a fourth embodiment will be described.

FIG. 5 is a drawing illustrating a rectifier according to the fourth embodiment.

As illustrated in FIG. 5, a rectifier 120 is provided with a first rectifying device 11, a second rectifying device 12, a first control element 21, a second control element 22, and a controller 30.

The first rectifying device 11 is connected in parallel to the second rectifying device 12. The first control element 21 is connected in series to the first rectifying device 11. The second control element 22 is connected in series to the second rectifying device 12.

The controller 30 generates a first control signal CS1 according to a change in the current i₁₁ flowing in the first rectifying device 10. The first control signal CS1 is a signal for changing the resistance value of the first control element 21 according to a change in the current i₁₁ flowing in the first rectifying device 11. The controller 30 generates a second control signal CS2 according to a change in the current i₁₂ flowing in the second rectifying device 12. The second control signal CS2 is a signal for changing the resistance value of the second control element 22 according to a change in the current i₁₂ flowing in the second rectifying device 12.

In this embodiment, a first driver 351 is provided between the controller 30 and the first control element 21, and a second driver 352 is provided between the controller 30 and the second control element 22. The first driver 351 generates a first gate voltage V_{gs1} according to the first control signal CS1. The first gate voltage V_{gs1} is applied to the MOSFET gate electrode that is the first control element 21. The controller 30 may also include the first driver 351. In this case, the controller 30 generates a first gate voltage V_{gs1} as the first control signal CS1.

The second driver 352 generates a second gate voltage V_{gs2} according to the second control signal CS2. The second gate voltage V_{gs2} is applied to a MOSFET gate electrode that is the second control element 22. The controller 30 may also include the second driver 352. In this case, the controller 30 generates the second gate voltage V_{gs2} as the second control signal CS2.

In such a rectifier 120, the current i₁₁ that flows in the first rectifying device 11, and the current i₁₂ that flows in the second rectifying device 12 are made to be uniform. In other words, in the rectifier 120, a balance is maintained between the current i₁₁ flowing in the first rectifying device 11 and the current i₁₂ flowing in the second rectifying device 12.

Here, a description will be given of a Reference Example.

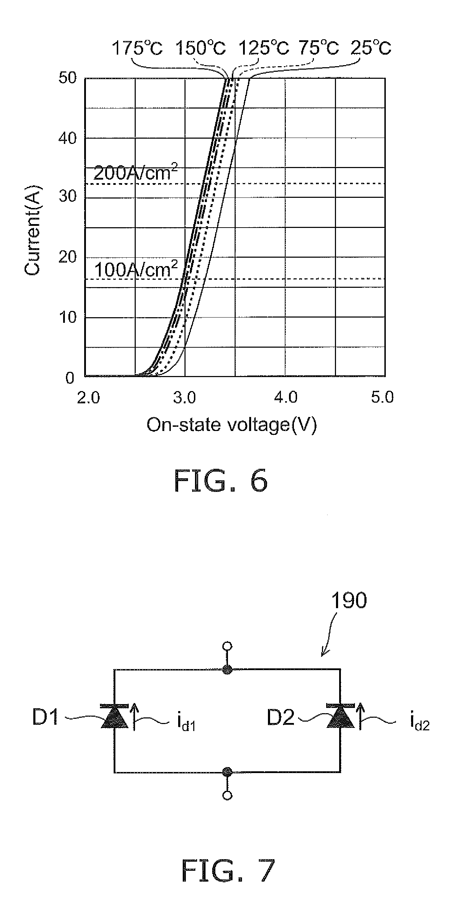

FIG. 6 is a chart showing a relationship between current and on-state voltage of the rectifying device.

FIG. 6 shows a relationship between current and on-state voltage when the temperature of the rectifying device is 25°C, 75°C, 125°C, 150°C, and 175°C. As shown in FIG. 6, as the temperature of the rectifying device increases, the on-state voltage decreases. This type of temperature characteristic is present in the rectifying device. There is variance to the temperature characteristic for each plural member of rectifying device.

FIG. 7 is a drawing illustrating a rectifier according to the Reference Example.

As illustrated in FIG. 7, two rectifying devices D1 and D2 are connected in parallel in a rectifier 190 according to the Reference Example.

When the two rectifying devices D1 and D2 are connected in parallel, current i_{d1} flows in the rectifying device D1, and current i_{d2} flows in the rectifying device D2. Here, when there is variance in temperature characteristic for these rectifying devices D1 and D2, a first rectifying device (for example, D1) has more current flowing than a second rectifying device (for example, D2). In this manner, when the first rectifying device has more current flowing, there is a greater burden on the first rectifying device which may cause a decrease in reliability for the rectifier 190.

As illustrated in FIG. 5, in the rectifier 120, the controller 30 controls the current i₁₁ that flows to the first rectifying device 11 and the current i₁₂ that flows to the second rectifying device 12 to be uniform. By this, even if there is variance in the temperature characteristics between the first rectifying device 11 and the second rectifying device 12, the flow of more current to either one of the rectifying devices can be suppressed.

For example, when the first rectifying device 11 and the second rectifying device 12 have negative temperature characteristics, the current increases in conjunction with a rise in temperature. When there is variance in negative temperature characteristics between the first rectifying device 11 and the second rectifying device 12, either one of the rectifying devices will have more current flowing in conjunction with the rise in temperature. In the rectifier 120, the flow of excess current in either the first rectifying device 11 or the second rectifying device 12 can be suppressed. Therefore, in the rectifier 120, a decrease in reliability caused by variance in temperature characteristics between the first rectifying device 11 and the second rectifying device 12 can be prevented.

Further, because excess current does not flow in either of the first rectifying device 11 or the second rectifying device 12 connected in parallel, there is no need in the design of the rectifier 120 to allow for margin in the rated current of the first rectifying device 11 and the second rectifying device 12. Accordingly, the chip size of the first rectifying device 11 and the second rectifying device 12 can be reduced to thereby achieve size reduction and cost reduction in the rectifier 120.

Note that, in the rectifier 120 illustrated in FIG. 5, a configuration that includes two rectifying devices (the first rectifying device 11 and the second rectifying device 12) is illustrated, but it is the same even for a configuration having three or more rectifying devices connected in parallel.

### (Fifth Embodiment)

Next, a fifth embodiment will be described.

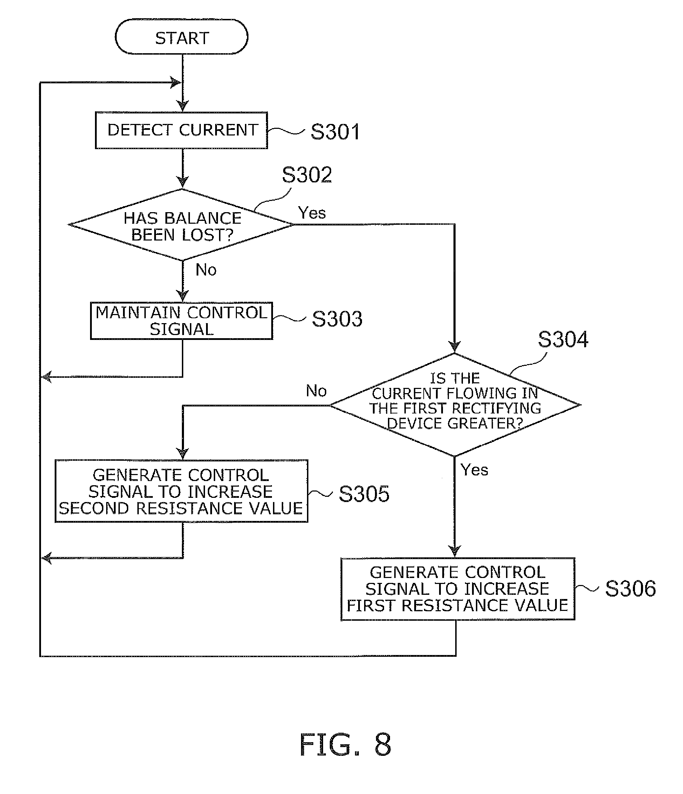

FIG. 8 is a flowchart illustrating a method for controlling the rectifier according to the fifth embodiment.

The flowchart illustrated in FIG. 8 is another example of a method for controlling the rectifier 120 depicted in FIG. 5. The control method illustrated in the flowchart is executed while the power is supplied to the rectifier 120.

First, as shown in step S301, the current i₁₁ and the current i₁₂ that flow in the first rectifying device 11 and the second rectifying device 12, respectively, are detected. Similar to the second embodiment, the current i₁₁ and the current i₁₂ can be determined from a value detected by any of the current detector 51, the voltage detector 52, or the temperature detector 53. The detected current i₁₁ and the current i₁₂ values are sent to the controller 30.

Next, as shown in step S302, a determination is made whether or not the balance has been lost between the detected current i₁₁ and the current i₁₂ values. This determination is made by the controller 30. The determination whether or not balance has been lost is made, for example, based on whether or not the difference between the detected current i₁₁ and the current i₁₂ is within a predetermined acceptable range. In other words, if the difference between the current i₁₁ and the current i₁₂ is within the acceptable range, then it is determined that the balance has not been lost. Meanwhile, if the difference between the current i₁₁ and the current i₁₂ exceeds the acceptable range, then it is determined that the balance has been lost.

In step S302, if it is determined that the balance has not been lost, the process proceeds to step S303. In step S302, if it is determined that the balance has been lost, the process proceeds to step S304.

In step S303, a process to maintain the first control signal CS1 and the second control signal CS2 is performed. In other words, the controller 30 maintains the generated first control signal CS1 and the second control signal CS2 without changing.

In step S304, a determination is made whether or not the detected current i₁₁ value of the first rectifying device 11 is greater than the current i₁₂ of the second rectifying device 12. This determination is made by the controller 30. If the detected current i₁₁ is not greater than the current i₁₂, then the process proceeds to step S305. If the detected current i₁₁ is greater than the current i₁₂, then the process proceeds to step S306.

In step S305, the second control signal CS2 to increase the resistance value (second resistance value) of the second control element 22 is generated by the controller 30. As the resistance value of the second control element 22 is increased according to the second control signal CS2, the current i₁₂ decreases. In other words, when the current i₁₂ of the second rectifying device 12 is greater than the current i₁₁ of the first rectifying device 11, the second control signal CS2 that increases the resistance value of the second control element 22 is generated, and by this, the current i₁₂ of the second rectifying device 12 decreases.

In step S306, the first control signal CS1 is generated by the controller 30 to increase the resistance value (first resistance value) of the first control element 21. As the resistance value of the first control element 21 is increased according to the first control signal CS1, the current i₁₁ decreases. In other words, when the current i₁₁ of the first rectifying device 11 is greater than the current i₁₂ of the second rectifying device 12, the first control signal CS1 that increases the resistance value of the first control element 21 is generated, and by this, the current i₁₁ of the first rectifying device 11 decreases.

By repeating such a process, the current i₁₁ that flows to the first rectifying device 11 and the current i₁₂ that flows to the second rectifying device 12 are made to be uniform. In other words, a balance is maintained between the current i₁₁ flowing in the first rectifying device 11 and the current i₁₂ flowing in the second rectifying device 12, and the reliability of the rectifier 120 is improved.

Note that the method for controlling the rectifier 120 according to the fifth embodiment may be implemented in combination with the control method according to the third embodiment described above. In other words, the control method according to the fifth embodiment may be implemented when a forward bias is being applied to the first rectifying device 11 and the second rectifying device 12 of the rectifier 120 according to the fifth embodiment, and the control method according to the third embodiment may be implemented when at least one of the first rectifying device 11 or the second rectifying device 12 has made a transition from a forward bias to a reverse bias.

### (Sixth Embodiment)

Next, a sixth embodiment will be described.

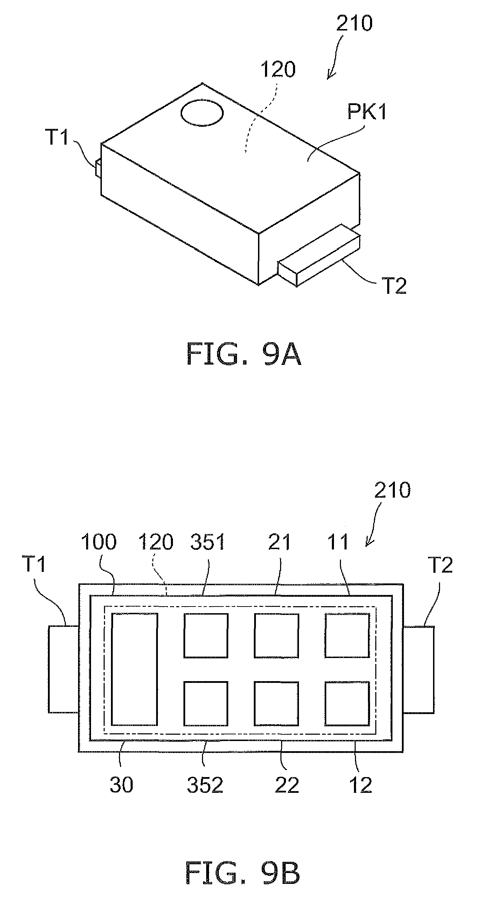

FIGS. 9A and 9B are drawings illustrating a semiconductor module according to the sixth embodiment.

FIG. 9A illustrates a schematic perspective view of a semiconductor module 210. FIG. 9B illustrates an internal configuration diagram of the semiconductor module 210. As illustrated in FIG. 9A, the semiconductor module 210 has, for example, a resin package PK1 and two terminals T1 and T2. The rectifier 120 described above is incorporated into the package PK1. Note that the rectifier 110 may be incorporated into the package PK1.

The terminal T1 is, for example, a cathode electrode. The terminal T2 is, for example, an anode electrode. FIG. 9B illustrates a housed state within the package PK1. The first rectifying device 11, the second rectifying device 12, the first control element 21, the second control element 22, the first driver 351, the second driver 352, and the controller 30 of the rectifier 120 are respectively chip components.

Each chip component is mounted on a substrate 100 and appropriately connected by wiring patterns and bonding wire (not illustrated) provided on a surface of the substrate 100. The package PK1 is provided so as to cover the substrate 100 and the chip components on the substrate 100. The package PK1 is provided in, for example, a rectangular parallelepiped shape. The terminal T1 and terminal T2 extend to an outer side from a side surface of the package PK1.

Note that the form of the package PK1 is not limited thereto. Moreover, the configuration of the rectifier 120 housed in the package PK1 is not limited thereto. A configuration in which a plurality of rectifiers 120 is provided in the package PK1 is possible.

### (Seventh Embodiment)

Next, a seventh embodiment will be described.

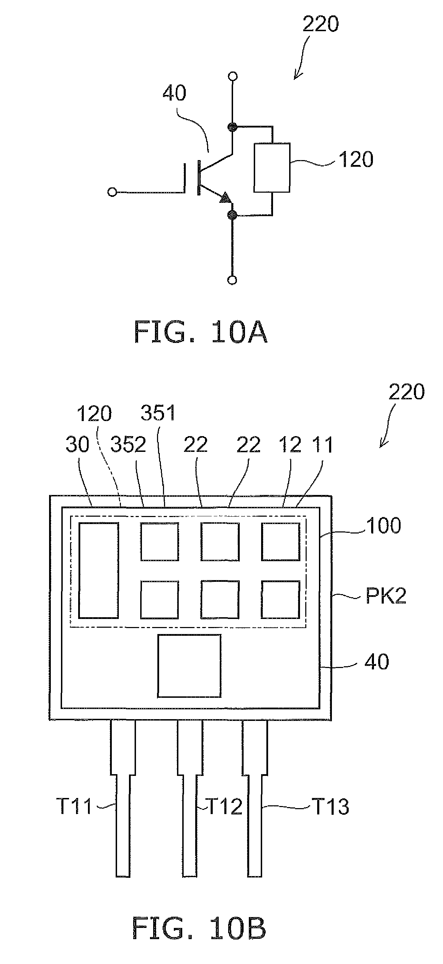

FIGS. 10A and 10B are drawings illustrating a semiconductor module according to the seventh embodiment.

FIG. 10A illustrates a configuration diagram of a semiconductor module 220. FIG. 10B illustrates an internal configuration diagram of the semiconductor module 220. As illustrated in FIG. 10A, the semiconductor module 220 includes an insulated gate bipolar transistor (IGBT) 40. The semiconductor module 220 includes the IGBT 40 and the rectifier 120 as a free wheeling diode (FWD) of the IGBT 40. Note that the rectifier 110 may be used as the FWD.

As illustrated in FIG. 10B, the semiconductor module 220 has, for example, a resin package PK2 and three terminals T11, T12, and T13. The IGBT 40 and the rectifier 120 are incorporated into the package PK2.

The terminal T11 is, for example, an emitter electrode of the IGBT 40. The terminal T12 is, for example, a gate electrode of the IGBT 40. The terminal T13 is, for example, a collector electrode of the IGBT 40.

The first rectifying device 11, the second rectifying device 12, the first control element 21, the second control element 22, the first driver 351, the second driver 352, and the controller 30 of the rectifier 120, as well as the IGBT 40, are respectively chip components.

Each chip component is mounted on a substrate 100 and appropriately connected by wiring patterns and bonding wire (not illustrated) provided on a surface of the substrate 100. The package PK2 is provided so as to cover the substrate 100 and the chip components on the substrate 100. The package PK2 is provided in, for example, a rectangular parallelepiped shape. The terminals T11, T12, and T13 extend to an outer side from a side surface of the package PK2.

In the semiconductor module 220, when the control method according to the third embodiment is applied as the method for controlling the rectifier 120, reverse bias state of the rectifier 120 is detected according to a signal given to the gate electrode of the IGBT 40 and the control method according to the third embodiment may be implemented.

Note that the form of the package PK2 is not limited thereto. Moreover, the configuration of the rectifier 120 and the IGBT 40 housed in the package PK2 are not limited thereto. A configuration in which a plurality of IGBT 40 and a plurality of rectifiers 120 are provided in the package PK2 is possible.

As described above, according to the rectifier and the control method thereof according to the embodiments, stable rectifier operation can be provided with high reliability.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A rectifier (110) comprising:
a rectifying device (10);
a control element (20) serially connected to the rectifying device (10), the control element (20) having a resistance value that changes according to a control signal (CS); and
a controller (30) generating the control signal (CS) according to a change in a current (i₁₀) flowing in the rectifying device (10).

2. The rectifier (110) according to claim 1, wherein the control element (20) is a normally-on type transistor.

3. The rectifier (110) according to claim 1, wherein an on-resistance of the control element (20) is less than an on-resistance of the rectifying device (10).

4. The rectifier (110) according to claim 1, wherein a breakdown voltage of the rectifying device (10) is greater than a breakdown voltage of the control element (20).

5. The rectifier (110) according to claim 1, further comprising a current detector (51) detecting the current (i₁₀) flowing in the rectifying device (10),
the controller (30) generating the control signal (CS) according to a change in the current (i₁₀) detected by the current detector (51).

6. The rectifier (110) according to claim 1, further comprising a temperature detector (53) detecting a temperature of the rectifying device (10),
the controller (30) generating the control signal (CS) that corresponds to the temperature detected by the temperature detector (53).

7. The rectifier (110) according to claim 1, further comprising a voltage detector (52) detecting a voltage applied to the rectifying device (10),
the controller (30) generating the control signal (CS) that corresponds to the voltage detected by the voltage detector(52).

8. The rectifier (110) according to claim 1, wherein the controller (30) generates the control signal (CS) for increasing the resistance value upon the rectifying device (10) making a transition from a forward bias state to a reverse bias state.

9. The rectifier (110) according to claim 1, wherein the rectifying device (10) is a diode made of SiC.

10. The rectifier (110) according to claim 1, wherein the control element (20) is a transistor made of Si.

11. The rectifier (110) according to claim 1, wherein the rectifying device (10) has a negative temperature characteristic.

12. A rectifier (120) comprising:
a first rectifying device (11), a first forward current flowing through the first rectifying device (11);
a second rectifying device (12) connected parallel to the first rectifying device (11), a second forward current flowing through the second rectifying device (12);
a first control element (21) serially connected to the first rectifying device (11) and having a first resistance value, the firstresistance value changing according to a first control signal (CS1);
a second control element (22) serially connected to the second rectifying device (12) and having a second resistance value, the resistance value changing according to a second control signal CS2); and
a controller (30) generating the first control signal (CS1) and the second control signal (CS2) so as to reduce a difference between the first forward current and the second forward current.

13. The rectifier (120) according to claim 12, wherein the first rectifying device (11) is a diode made of SiC, and
the second rectifying device (12) is a diode made of SiC.

14. The rectifier (120) according to claim 12, wherein the first control element (21) is a transistor made of Si, and
the second control element (22) is a transistor made of Si.

15. The rectifier (120) according to claim 12, wherein the first rectifying device (11) has a negative temperature characteristic, and
the second rectifying device (12) has a negative temperature characteristic.

16. A method for controlling a rectifying device (10) comprising:
detecting a current (i₁₀) flowing in the rectifying device (10); and
changing a resistance value of a control element (20) which is serially connected to the rectifying device (10) by giving a control signal (CS) which corresponds to a change in the current (i₁₀) to the control element (20).

17. The method according to claim 16, wherein giving the control signal (CS) to the control element (20) includes giving the control signal (CS) to the control element (20) so that the resistance value increases when the current (i₁₀) of the rectifying device (10) exceeds a predetermined acceptable range.

18. The method according to claim 16, wherein giving the control signal (CS) to the control element (20) includes giving the control signal (CS) to the control element (20) so that the resistance value increases when the rectifying device (10) makes a transition from a forward bias state to a reverse bias state.

19. The method according to claim 16, wherein the rectifying device (10) is a diode made of SiC, and
the control element (20) is a transistor made of Si.

20. The method according to claim 16, wherein the rectifying device (10) has a negative temperature characteristic.

21. A method for controlling a rectifier (120) comprising:
detecting a first forward current flowing in a first rectifying device (11) and a second forward current flowing in a second rectifying device (12) connected in parallel to the first rectifying device (11); and
giving a first control signal (CS1) to the first control element (21) so that a first resistance value of the first control element (21) serially connected to the first rectifying device (11) increases when the first forward current is greater than the second forward current, and giving a second control signal (CS2) to the second control element (22) so that a second resistance value of the second control element (22) serially connected to the second rectifying device (12) increases when the second forward current is greater than the first forward current.
